# EUROPÄISCHE PATENTSCHRIFT

(11) **EP 2 082 191 B1**
(45) Veröffentlichungstag und Bekanntmachung des Hinweises auf die Patenterteilung: **12.08.2015**
(21) Anmeldenummer: 07803359.4
(22) Anmeldetag: 10.09.2007
(51) Int. Cl.: G01D 3/02, G01D 9/00

(54) **FELDGERÄT ZUR BESTIMMUNG UND ÜBERWACHUNG EINER PROZESSGRÖßE IN DER PROZESSAUTOMATISIERUNG**
FIELD DEVICE FOR DETERMINING AND MONITORING A PROCESS VARIABLE IN PROCESS AUTOMATION SYSTEMS
APPAREIL DE CHAMP DESTINÉ À LA DÉTERMINATION ET À LA SURVEILLANCE D'UNE GRANDEUR DE PROCESSUS DANS L'AUTOMATISATION DE PROCESSUS

(30) Priorität: 17.10.2006 DE 102006049509; 17.10.2006 DE 102006049501; 17.10.2006 DE 102006049502
(43) Veröffentlichungstag der Anmeldung: 29.07.2009
(73) Patentinhaber: Endress+Hauser GmbH+Co. KG, 79689 Maulburg (DE)
(72) Erfinder: GRITTKE, Udo, 79585 Steinen (DE); HUMPERT, Axel, 77866 Reinau (DE); FRÜHAUF, Dietmar, 79539 Lörrach (DE)
(74) Vertreter: Andres, Angelika Maria
(86) Internationale Anmeldenummer: PCT/EP2007/059441
(87) Internationale Veröffentlichungsnummer: WO 2008/046695

(56) Entgegenhaltungen:
- EP-A- 1 108 984
- EP-A- 1 450 137
- WO-A-03/098154
- DE-A1- 10 161 401
- US-A1- 2004 162 694

## Beschreibung

Die Erfindung betrifft ein Feldgerät zur Bestimmung oder Überwachung einer Prozessgröße in der Prozessautomatisierung, bestehend aus einem Sensor, der nach einem definierten Messprinzip arbeitet, und einer Kontroll-/Auswerteeinheit, die die vom Sensor gelieferten Messdaten aufbereitet und auswertet.

In der Automatisierungstechnik, insbesondere in der Prozessautomatisierungstechnik werden vielfach Feldgeräte eingesetzt, die zur Bestimmung und Überwachung von Prozessvariablen dienen. Beispiele für derartige Feldgeräten sind Füllstandsmessgeräte, Durchflussmessgeräte, Analyse-messgeräte, Druck- und Temperaturmessgeräte, Feuchte- und Leitfähigkeitsmessgeräte, Dichte und Viskositätsmessgeräte. Die Sensoren dieser Feldgeräte erfassen die entsprechenden Prozessvariablen, z.B. den Füllstand, den Durchfluss, den pH-Wert, die Stoffkonzentration, den Druck, die Temperatur, die Feuchte, die Leitfähigkeit, die Dichte oder die Viskosität.

Unter den Begriff 'Feldgeräte' werden aber auch Aktoren, z. B. Ventile oder Pumpen, subsumiert, über die beispielsweise der Durchfluss einer Flüssigkeit in einer Rohrleitung oder der Füllstand in einem Behälter veränderbar ist. Eine Vielzahl solcher Feldgeräte wird von der Firmengruppe Endress + Hauser angeboten und vertrieben.

In der Regel sind Feldgeräte in modernen automatisieuungstechnischen Anlagen über Kommunikationsnetzwerke (HART- Multidrop, Punkt zu Punkt Verbindung, Profibus, Foundation Fieldbus etc.) mit einer übergeordneten Einheit, die als Leitsysteme oder Leitwarte bezeichnet wird, verbunden. Diese übergeordnete Einheit dient zur Prozesssteuerung, Prozessvisualisierung, Prozessüberwachung sowie zur Inbetriebnahme bzw. zum Bedienen der Feldgeräte.

Notwendige Zusatzkomponenten zum Betrieb von Feldbussystemen, die direkt an einen Feldbus angeschlossen sind und die insbesondere zur Kommunikation mit den übergeordneten Einheiten dienen, werden ebenfalls häufig als Feldgeräte bezeichnet. Bei diesen Zusatzkomponenten handelt es sich z. B. um Remote I/Os, um Gateways, um Linking Devices oder um Controller.

Bekannt ist es auch, Feldbussysteme in Unternehmensnetzwerke zu integrieren, die auf Ethernet-Basis arbeiten. Diese unternehmensinternen Bussysteme erlauben es, aus unterschiedlichen Bereichen eines Unternehmens auf Prozess- bzw. Feldgeräteinformationen zuzugreifen. Darüber hinaus ist es Stand der Technik, dass zwecks weltweiter Kommunikation Firmennetzwerke mit öffentlichen Netzwerken, z. B. dem Internet, verbunden werden.

Zum Bedienen und zur Inbetriebnahme der Feldgeräte sind entsprechende Bedienprogramme notwendig. Bekannt sind hier beispielsweise das Bedienprogramm FieldCare von Endress+Hauser, das Bedienprogramm AMS von Emerson und das Bedienprogramm Simatic PDM von Siemens.

Zur Steuerung und Überwachung von Anlagen mit einer Vielzahl von Feldgeräten dienen Leitsystem-Anwendungen, wie z. B. Simatic S7 von Siemens, Freelance von ABB und Delta V von Emerson.

Ein wesentlicher Aspekt der offenen Kommunikationssysteme, wie z. B. Profibus, Foundation Fieldbus oder HART, ist die Interoperabilität und die Austauschbarkeit von Geräten unterschiedlicher Hersteller. So können Sensoren oder Aktoren verschiedener Hersteller problemlos gemeinsam in einer Anlage eingesetzt werden. Auch ist es möglich, ein Feldgerät eines Herstellers durch ein funktionsgleiches Feldgerät eines anderen Herstellers zu ersetzen, wodurch der Kunde ein Höchstmaß an Freiheit bei der Konfiguration seiner Prozessanlage hat.

Feldgeräte werden hinsichtlich ihrer Funktionalität zunehmend komplexer. Neben der reinen Messwertverarbeitung werden Diagnoseaufgaben und vor allem Komununikationsaufgaben, die die Feldgeräte im Hinblick auf die eingesetzten Bussysteme erfüllen müssen, immer aufwändiger. Noch komplexer werden die Funktionalitäten bei Feldgeräten mit Multisensorik, die in der Lage sein müssen, zumindest zwei Prozessgrößen simultan zu bestimmen oder zu überwachen. Um den steigenden Anforderungen gerecht zu werden, sind in einem Feldgerät oft mehrere Mikrocontroller parallel vorgesehen.

Der Vorteil beim Einsatz von Mikrocontrollern besteht darin, dass über anwendungsspezifische Softwareprogramme, die in diesen Mikrocontrollern ablaufen, die verschiedensten Funktionalitäten realisierbar sind und dass Programmänderungen relativ einfach durchgeführt werden können. Programmgesteuerte Feldgeräte sind in hohem Maße flexibel. Diese hohe Flexibilität wird aber mit dem Nachteil erkauft, dass durch die sequentielle Programmabarbeitung die Verarbeitungsgeschwindigkeit verlangsamt wird.

Um die Verarbeitungsgeschwindigkeit zu erhöhen, werden immer dann, wenn es sinnvoll ist, in den Feldgeräten ASICs - Application Specific Integrated Circuits - eingesetzt. Durch die anwendungsspezifische Konfiguration können diese Bausteine Daten und Signale wesentlich schneller verarbeiten, als dies ein Softwareprogramm tun kann. Insbesondere für rechenintensive Anwendungen sind ASICs hervorragend geeignet.

Nachteilig bei der Applikation von ASICs ist, dass die Funktionalität dieser Bausteine fest vorgegeben ist. Eine nachträgliche Änderung der Funktionalität ist bei diesen Bausteinen nicht ohne Weiteres möglich. Weiterhin zahlt sich der Einsatz von ASICs nur bei relativ großen Stückzahlen aus, da der Entwicklungsaufwand und die damit verbundenen Kosten hoch sind.

Um den Missstand der fest vorgegebenen Funktionalität zu umgehen, ist aus der WO 03/098154 ein konfigurierbares Feldgerät bekannt geworden, bei dem ein rekonfigurierbarer Logikbaustein in Form eines FPGAs vorgesehen ist. Bei dieser bekannten Lösung wird beim Systemstart der Logikbaustein mit mindestens einem Mikrocontroller, der auch als Embedded Controller bezeichnet wird, konfiguriert. Nachdem die Konfiguration abgeschlossen ist, wird die erforderliche Software in den Mikrocontroller geladen.

Der hierbei benötigte rekonfigurierbare Logikbaustein muss über ausreichende Ressourcen, und zwar Logik-, Verdrahtungs- und Speicherressourcen, verfügen, um die gewünschten Funktionalitäten zu erfüllen. Logikbausteine mit vielen Ressourcen benötigen viel Energie, was wiederum ihren Einsatz in der Prozessautomatisierung uneingeschränkt möglich macht. Nachteilig beim Einsatz von Logikbausteinen mit wenigen Ressourcen und somit mit einem geringeren Energieverbrauch ist die erhebliche Einschränkung in der Funktionalität des entsprechenden Feldgeräts.

Der Erfindung liegt die Aufgabe zugrunde, ein Feldgerät vorzuschlagen, das für den flexiblen Einsatz in unterschiedlichsten Applikationen in der Prozessautomatisierungstechnik nutzbar ist.

Die Aufgabe wird dadurch gelöst, dass die die Kontroll-/Auswerteeinheit als rekonfigurierbarer Logikbaustein FPGA mit mehreren dynamisch rekonfigurierbaren Funktionsmodulen ausgebildet ist - es handelt sich somit um einen partiell dynamisch rekonfigurierbarer Logikbaustein. Weiterhin ist eine Schnittstelle vorgesehen, über die die Kontroll-/Auswerte-einheit sensor- und applikationsspezifische Information über den definierten Sensortyp in der jeweils definierten Prozess-Applikation erhält. Die Kontroll-/Auswerteeinheit konfiguriert die Funktionsmodule entsprechend der sensor- und applikationsspezifischen Information derart, dass das Feldgerät optimal an die zu bestimmende bzw. zu überwachende Prozessgröße und an die aktuelle Prozess-Applikation angepasst ist. Die ausgewählte sensor- und applikationsspezifische Information wird beispielsweise während der Fertigung in den Flash-Speicher geladen und von der Kontroll-/Auswerte-einheit nachfolgend konfiguriert. Alternativ kann auch die komplette Funktionalität für unterschiedlichste Anwendungen und Sensoren in den Flasch-Speicher geladen werden, so dass nachfolgend hinsichtlich der Auswahl des Sensors in der jeweiligen Applikation eine große Flexibilität vorliegt. Möglich ist es dann, das Feldgerät für eine anderweitige Applikation zu einem späteren Zeitpunkt beliebig umzukonfigurieren.

Bevorzugt handelt es sich bei den Funktionsmodulen um Mikroprozessoren mit unterschiedlicher Bus-Breite, um A/D-Wandler oder D/A-Wandler mit unterschiedlicher Bit-Auflösung, um Signalfilter mit unterschiedlichen Filterfunktionen, um unterschiedliche Skalierungen von Auswertealgorithmen bzw. Polynomen, um unterschiedliche Modems, um unterschiedliche Stromsteuereinheiten oder um Ansteuereinheiten für unterschiedliche Ein-/Ausgabeeinheiten.

Eine vorteilhafte Ausgestaltung des erfindungsgemäßen Feldgeräts sieht vor, dass die Kontroll-/Auswerteeinheit zumindest einen statischen Bereich aufweist, in dem zumindest eine Basiskomponente, wie beispielsweise der Mikrocontroller, permanent konfiguriert ist. Da die Komponenten im statischen Bereich bevorzugt festverdrahtet sind, zeichnen sie sich durch eine hohe Verarbeitungsgeschwindigkeit aus. Eine partiell dynamische Rekonfiguration macht hier auch wenig Sinn, da - bei Verwendung von nur einem Mikrocontroller - dieser in seiner Funktion als Steuereinheit für das Konfigurieren der Funktionsmodule permanent konfiguriert sein muss.

Darüber hinaus wird im Zusammenhang mit dem erfindungsgemäßen Feldgerät vorgeschlagen, dass es sich bei der sensorspezifischen Information um Information handelt, die den Sensor in seiner Funktion zur Bestimmung oder Überwachung einer Prozessgröße über ein definiertes Messprinzip kennzeichnet. Ist die zu überwachende Prozessgröße beispielsweise der Durchfluss, so können Durchflussmessgeräte eingesetzt werden, die beispielsweise auf dem Coriolis-Prinzip oder dem Prinzip der Karman'schen Wirbelstraße basieren. Weiterhin kann der Durchfluss über die Messung der Laufzeitdifferenz von Ultraschall-Messsignalen erfolgen, oder sie kann auf dem Prinzip der elektromagnetischen Induktion beruhen.

Es versteht sich von selbst, dass es sich bei der Prozessgröße um unterschiedlichste physikalische oder chemische Prozessgrößen handeln kann. Beispielhaft werden an dieser Stelle folgende Prozessgrößen genannt: Füllstand, Druck, Durchfluss, Temperatur, Leitfähigkeit, pH-Wert, Trübung, Dichte, Viskosität oder Konzentration eines chemischen Stoffes.

Bei der applikationsspezifischen Information handelt es sich um Information über die definierte Applikation, in welcher das Feldgerät im Prozess eingesetzt ist. So kann es sich bei dieser Information um die Information handeln, in welcher Betriebsart z.B. ein Drucksensor arbeitet. Mögliche Betriebsarten eines Drucksensors sind die Druckmessung, die Füllstandsmessung oder die Durchflussmessung. Bei der Druckmessung wiederum wird unterschieden, ob das Feldgerät den Relativdruck, den Absolutdruck oder den Differenzdruck, kompensiert mit dem Relativdruck, misst.

Weiterhin kann es sich bei der applikationsspezifischen Information um Information handeln, ob das Feldgerät in einem Prozess eingesetzt ist, bei dem sich die zu messende Prozessgröße im wesentlichen kontinuierlich ändert, oder ob in dem überwachten Prozess mit sprunghaften Änderungen der Prozessgröße zu rechnen ist.

Als Beispiel für eine sprunghaft sich ändernde Prozessgröße sei ein Druckstoß bzw. ein sog. Wasserhammer genannt. Ein Druckstoß entsteht, wenn in einer flüssigkeitsführenden Rohrleitung eine Armatur oder ein Ventil zu schnell geschlossen oder geöffnet wird. Die kinetische Energie der sich in der Rohrleitung bewegenden Flüssigkeitssäule bewirkt vor der Armatur durch ihren niedrigen Kompressionsmodul einen sehr raschen Anstieg des Druckes. Das gleiche geschieht hinter der Armatur, allerdings entsteht hier zunächst eine Dampfblase mit einem niedrigeren Druck, während sich die Flüssigkeitssäule weiterbewegt. Irgendwann aber kehrt die Flüssigkeitssäule wegen des in der Rohrleitung herrschenden Druckgefälles ihre Bewegungs-richtung um und schlägt in die Armatur zurück. Je nach der Wucht des Aufpralls können/kann die Armatur und/oder die anschließenden Rohrleitungen bei diesem Vorgang zerstört werden. Ähnliche Probleme können beim Öffnen der Armatur auftreten. Es ist durchaus üblich, dass Druckänderungen vor und hinter der Armatur sich in einem Bereich von 20 bar und 100 mbar abs. bewegen. Diese sprunghaften Druckerhöhungen und Druckerniedrigungen erfolgen so schnell, dass sie mit herkömmlichen Druckmessgeräten überhaupt nicht messbar sind. Herkömmliche Druckmessgeräte zeichnen sich bevorzugt durch eine hohe Messgenauig-keit bei sich langsam ändernden Drücken aus. Da die extremen Druckschwankungen nicht selten zum Ausfall des Druckmeßgeräts führen, ist es im Rahmen der vorausschauenden Wartung unerlässlich, die Druckstöße zu erfassen, aufzulisten und ggf. geeignet auf sie zu reagieren.

Mit dem erfindungsgemäßen Feldgerät, dessen Kontroll-/Auswerteeinheit für die eines Druckmessgeräts konfiguriert ist, lässt sich das Auftreten von Wässerhämmern detektieren. Ist das Auftreten der Wasserhämmer und ihre Wirkung detektierbar, so können geeignete Gegenmaßnahmen getroffen werden, die einem sprunghaften Anstieg und Abfall der Druckwerte in der Rohleitung entgegenwirken. Beispielsweise können in der Rohrleitung schnell steuerbare Ventile eingesetzt werden, die in Kenntnis des Druckstoßes einen geeigneten Kompensationsvorgang durchführen.

Um sprunghafte Änderungen zu detektieren und nachfolgend angemessen auf sie reagieren zu können, schlägt eine Weiterbildung des erfindungs-gemäßen Feldgeräts vor, dass im laufenden Messbetrieb eine Überwachungsfunktion überprüft, ob sprunghafte Änderungen der Prozessgröße auftreten. Werden sprunghafte Änderungen augenfällig, oder aber ist ihr Auftreten von vorne herein bekannt, so konfiguriert die Kontroll-/Auswerteeinheit Funktionsmodule, insbesondere den A/D-, den D/A- und Filter, mit einer höheren Bit-Auflösung, als dies der Fall ist, wenn sich die Prozessgröße langsam ändert oder wenn sie im wesentlichen einen konstanten Werte annimmt. Bei gängigen Druckmessgeräten liegt der Schwerpunkt auf einer Druckmessung mit einer hohen Messgenauigkeit. Die elektronischen Auswertekomponenten sind so gewählt, dass sie eine hohe Bit-Auflösung aufweisen. Die Verarbeitungsgeschwindigkeit ist somit relativ langsam. Um die pulsartigen Wasserhämmer zu detektieren, ist hingegen eine hohe Verarbeitungsgeschwindigkeit erforderlich, was nur machbar ist, wenn Wandlerkomponenten mit einer geringeren Bitauflösung eingesetzt werden. Erfindungsgemäß werden stets die Funktionsmodule konfiguriert, die optimal auf die im Prozess herrschenden Gegebenheiten abgestimmt sind.

Erfindungsgemäß ist es in einer alternativen Ausgestaltung auch möglich, immer dann, wenn ein Armatur betätigt wird, die Funktionsmodule zu konfigurieren, die in der Lage sind, sprunghafte Druckänderungen zu detektieren, während im normalen Messbetrieb die Funktionsmodule so konfiguriert sind, dass sie für eine hohe Messgenauigkeit ausgelegt sind. Die entsprechende Information erhält die Kontroll-/Auswerteeinheit über eine geeignete Überwachungsfunktion, die ihr beispielsweise über den Bus zur Verfügung gestellt wird.

Eine weitere alternative Ausgestaltung des erfindungsgemäßen Feldgeräts sieht vor, dass die Kontroll-/Auswerteeinheit zumindest temporär (etwa nach dem Öffnen oder Schließen eines Ventils) parallele Zweige von Funktionsmodulen konfiguriert. Der erste Zweig ist für die Verarbeitung von sich sprunghaft ändernden Prozessgrößen geeignet; der zweite Zweig ist für die Verarbeitung von sich im wesentlichen kontinuierlich ändernden Prozessgrößen ausgelegt. Entweder arbeiten beide Zweige parallel, oder der für die Applikation geeignete Zweig wird über die Überwachungsfunktion angesteuert.

Die Erfindung wird anhand der nachfolgenden Figuren näher erläutert. Es zeigt:
Fig. 1: eine Ausgestaltung der erfindungsgemäßen partiell dynamisch konfigurierten Kontroll-/Auswerteeinheit für ein Druckmessgerät und
Fig. 2: eine Würfelanordnung einer Vielzahl von Funktionalitäten, mit denen unterschiedliche Kontroll-/Auswerteeinheiten für Feldgeräte konfiguriert werden können.

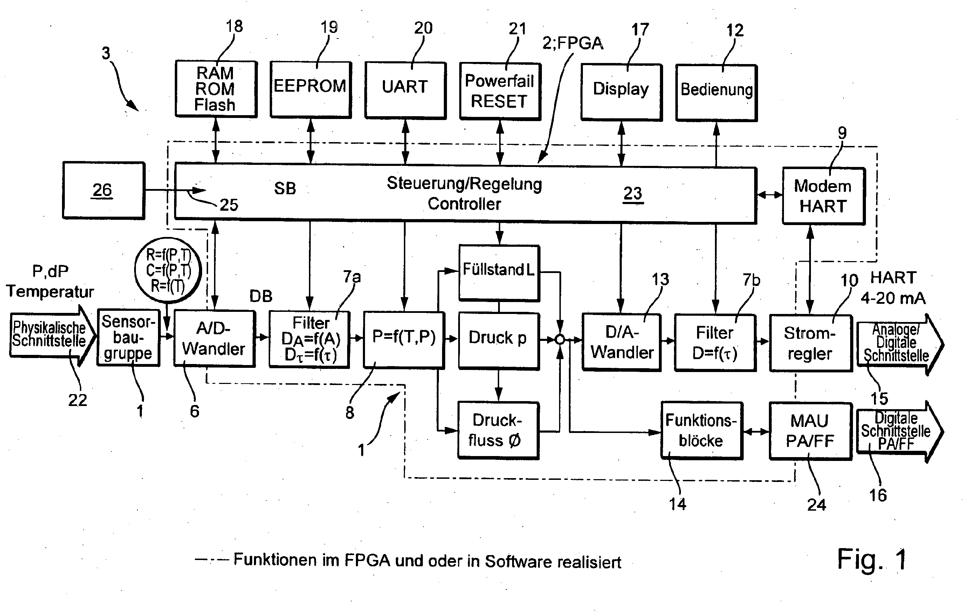

Fig. 1 zeigt die Kontroll-/Auswerteeinheit 2 eines Sensors 1 - hier eines Drucksensors -, welche als partiell dynamisch rekonfigurierbarer Logikbaustein FPGA 2 mit einer Vielzahl von dynamisch rekonfigurierbaren Funktionsmodulen 4 ausgestaltet ist. Zwei alternative Verfahren, wie sich Logikbausteine partiell dynamisch rekonfigurieren lassen, ist in zwei Internationalen Patentanmeldungen beschrieben, die den gleichen Anmeldetag wie die vorliegende Internationale Patentanmeldung aufweisen und die ebenfalls die Prioritäten von drei am 17.10.2006 hinterlegten Patentanmeldungen: DE 10 2006 049 509.8, DE 10 2006 049 501.2, DE 10 2006 049 502.0 in Anspruch nehmen. Der Inhalt dieser beiden Internationalen Patentanmeldungen ist explizit dem Offenbarungsgehalt der vorliegenden Patentanmeldung zuzurechnen, so dass an dieser Stelle auf eine Wiederholung der beiden bereits beschriebenen erfindungsgemäßen Lösungen verzichtet werden kann.

An der Kontroll-/Auswerteeinheit 2 ist zumindest eine Schnittstelle 25 vorgesehen, über die die Kontroll-/Auswerteeinheit 2 sensor- und applikationsspezifische Information über einen definierten Sensortyp - hier also den Drucksensor 1 - in einer definierten Prozess-Applikation - hier der Druckmessung - erhält. Die Kontroll-/Auswerteeinheit 2 konfiguriert die Funktionsmodule 4 entsprechend der über die Schnittstelle 25 zur Verfügung gestellten sensor- und applikationsspezifischen Information, so dass das Feldgerät 3 optimal an die zu bestimmende bzw. zu überwachende Prozessgröße p und an die aktuelle Prozess-Applikation des Feldgeräts 3 angepasst ist. Die sensor- und applikationsspezifische Information erhält die Kontroll-/Auswerteeinheit 2 bevorzugt bei der Fertigung des Feldgeräts 3. Möglich ist es jedoch auch, das Feldgerät 3 für eine anderweitige Applikation zu einem späteren Zeitpunkt umzukonfigurieren. Diese Rekonfiguration kann gleichfalls über das Bedientool 12 initiiert werden. Die Funktionsmodule 4 sind in dem FLASH-Speicher 18 gespeichert.

Über die physikalische Schnittstelle 22 detektiert die Sensorbaugruppe 1, bestehend aus einem Druck- und einem Temperatursensor, den Druck p, ggf. den Differenzdruck dp und die Temperatur T. Am Ausgang der Sensorbaugruppel stehen ein Druckmesssignal in Form eines Widerstands-signals R = f(p, T)) oder eines Kapazitätssignals C= f(p, T) und ein Temperaturmesssignal in Form eines Widerstandswertes R(T) zur Verfügung. Wie durch die funktionale Abhängigkeit angedeutet, ist das Druckmesssignal sowohl von dem Druck als auch von der Temperatur abhängig.

Die Widerstands- oder Kapazitätswerte R, C werden einem A/D-Wandler 6 zugeführt und anschließend über das Filter 7a gefiltert. Anhand von entsprechenden Kennlinien, hierbei handelt es sich üblicherweise um Polynome, die in der Einheit 8 berechnet werden, wird im dargestellten Fall der im Prozess herrschende Druck p ermittelt.

Wie bereits zuvor erwähnt, werden Drucksensoren nicht nur in der Betriebs-art: Druckmessung, sondern auch in den Betriebsarten: Durchflussmessung und Füllstandsmessung eingesetzt. Erfindungsgemäß lässt sich die Kontroll-/Auswerteeinheit 1 dynamisch so konfigurieren, dass das Feldgerät 3 in Abhängigkeit von der jeweiligen Applikation alternativ für die Durchfluss-messung oder für die Füllstandsmessung geeignet ist. Entsprechende Funktionsmodule L, Φ können dynamisch partiell konfiguriert werden.

Die jeweils aktuell benötigten Funktionsmodule 4 werden auf Anforderung des im Mikrocontroller 23 ablaufenden Steuerprogramms auf dem Logikbaustein FPGA partiell dynamisch konfiguriert. Die Konfigurierung der Funktionsmodule 4 erfolgt in einfacher Weise über einen Konfigurations-bitstrom, der aus einem Speicher FLASH 27 geladen wird. Beschrieben ist die Konfigurierung der Funktionsmodule 4 im Detail in den beiden bereits zuvor genannten Internationalen Patentanmeldungen, deren Inhalt dem Offenbarungsgehalt der vorliegenden Patentanmeldung zuzurechnen ist.

Als vorteilhaft wird es angesehen, auf dem dynamisch rekonfigurierbaren Logikbaustein FPGA 2 zwei Bereiche vorzusehen, einen dynamischen Bereich DB und einen statischen Bereich SB. In dem statischen Bereich SB ist im dargestellten Fall permanent der Mikrocontroller 23 konfiguriert; hier läuft das Steuerprogramm zur Konfiguration der dynamischen Bereiche des Logikbausteins FPGA 2 ab. Der dynamische Bereich DB ist für die einzelnen dynamisch konfigurierbaren Funktionsmodule 4 vorgesehen.

Erfindungsgemäß werden stets nur die Funktionsmodule partiell konfiguriert, und somit die Ressourcen verwendet, die aktuell benötigt werden (siehe erste Internationale Patentanmeldung). Durch die hiermit verbundene Einsparung von Fläche und Ressourcen verbraucht die Kontroll-/Auswerteeinheit 2 nur einen Bruchteil der Energie, die ein übliches FPGA benötigt. Wird dieser Vorteil mit dem Vorteil der Lösung verknüpft, die auf festverdrahteten ASIC Strukturen basiert (siehe zweite Internationale Patentanmeldung), so zeichnet sich die erfindungsgemäße Kontroll-/Auswerteeinheit zusätzliche durch die hohe Verarbeitungsgeschwindigkeit eines ASICs aus.

Die Funktionsmodule 4 decken alle notwendigen Funktionalitäten ab, wie beispielsweise die Digital-/Analog-Wandlung und die Filterung des Messsignals, die Generierung eines Ausgabewertes für die Kommunikationsschaltung und die Ansteuerung der Anzeige/Bedieneinheit.

Ein Feldgerät 3 mit einem partiell dynamisch rekonfigurierbaren Logikbau-stein FPGA 2 bietet den Vorteil, dass nur aktuell benötigte Funktionsmodule 4 konfiguriert werden. Alle weiteren Funktionalitäten stehen prinzipiell zur freien Verfugung, da sie als Funktionsmodule 4 in einem Speicherelement 18 gespeichert sind und jederzeit konfiguriert werden können, soweit die entsprechenden Ressourcen verfügbar sind.

Durch die partiell dynamische Konfiguration können relativ kleine FPGA-Bausteinen mit wenig Speicherplatz verwendet werden. Je kleiner die Logikbausteine sind, um so weniger Energie benötigen sie, obwohl sie in der Lage sind, ein hohes Maß an Funktionalität zur Verfügung zu stellen. Auch ist mit Hilfe der partiell dynamische Konfiguration einer sehr schnelle Datenverarbeitung möglich, da für aktuell benötigte Funktionalitäten prinzipiell alle Ressourcen des dynamischen Bereichs DB zur Verfügung stehen, wodurch eine parallele Abarbeitung möglich ist. Aufgrund des geringen Energieverbrauchs kann das Feldgerät 3 über einen Feldbus 24 bzw. eine Prozessregelschleife 10 mit Energie versorgt werden (loop powered), ohne dass eine separate Energieversorgungsleitung notwendig ist.

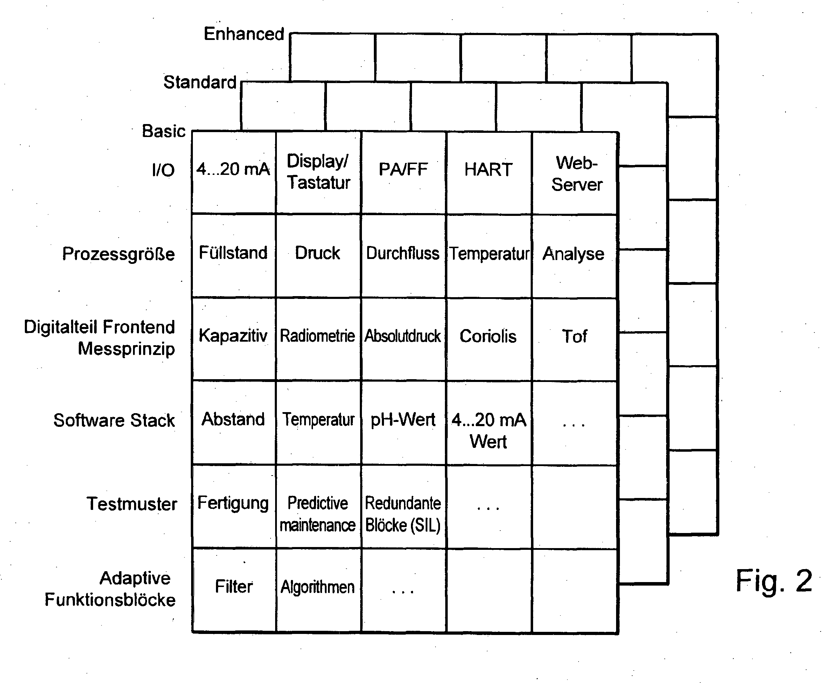

Während in Fig. 1 ein konkretes Ausgestaltungsbeispiel des erfindungs-gemäßen Feldgeräts 3 beschrieben ist, vermittelt das in Fig. 2 gezeigte dreidimensionale Schema in der Form eines Würfels einen Eindruck von dem enormen Gestaltungspotential, das die erfindungsgemäße Lösung für die Prozessautomatisierungstechnik eröffnet. Durch Kombination der unterschiedlichen Varianten und Ausgestaltungen, lässt sich jedes beliebige Feldgerät 3 zur Bestimmung einer Prozessgröße konfigurieren. üblicherweise erfolgt diese Konfiguration im Rahmen des Fertigungsprozesses. Gespeichert ist die Information in dem FLASH-Speicher 18. Neben dem Konfigurieren der geeigneten Kontroll-/Auswerteeinheit 2 für den ausgewählten Sensortyp, kann die Kontroll-/Auswerteeinheit 2 auch jederzeit optimal an die jeweilige Applikation angepasst werden. So lässt sich das Feldgerät 3 hoch flexibel mit der Funktionalität unterschiedlicher Geräteklassifikationen ausstatten. Diese sind in Fig. 2 mit BASIC, STANDARD oder ENHANCED gekennzeichnet.

Nachfolgend wird der in Fig. 2 dargestellte Würfel im Detail beschrieben: In den Zeilen der im Vordergrund befindlichen Würfelebene sind in einer sinnvollen Sortierung unterschiedliche Komponenten eines Feldgeräts 3 aufgeführt. Es versteht sich von selbst, dass es sich bei den dargestellten Funktionalitäten nur um eine Auswahl handelt und dass aufgrund der Vielfalt der Variationen nur einige wenige explizit dargestellt sind. Die entsprechenden konfigurierbaren Funktionsmodule sind im Feldgerät 3 gespeichert.

Unter der ersten Bezeichnung I/O - Input/Output - finden sich einige der bekannten Ein- und Ausgänge:
- ein Ein-/Ausgang für ein 4..20 mA Messsignal;
- eine Ein- und/oder Ausgabeeinheit in Form eines Displays 17 oder einer Tastatur;
- ein Anschluss für eine digitale Datenkommunikation via Feldbus, z.B. Profibus PA oder Fieldbus Foundation FF;
- ein HART Anschluss;
- ein Anschluss ans Internet oder an ein firmeninternes Intranet.

In der zweiten Zeile finden sich beispielhaft unterschiedliche Prozessgrößen, die über das Feldgerät 3 bestimmt oder überwacht werden können: Aufgelistet sind hier explizit: Füllstand, Druck, Durchfluss, Temperatur und Analyse.

Unterschiedliche Möglichkeiten für das Digitalteil am Frontend sind in der dritten Zeile aufgelistet und mit Kapazitiv, Radiometrie, Absolutdruck, Coriolis und Time of Flight (ToF) bezeichnet.

Unter der vierten Zeile 'Software Stack' sind die unterschiedlichen Ausgabewerte der Prozessgröße aufgelistet, wie Abstand, Temperatur, pH-Wert oder 4...20mA.

In der fünften Zeile sind Testmuster vorgesehen, wie sie in der Fertigung oder zu Zwecken der vorausschauenden Wartung oder für SIL-Anwendungen geeignet sind.

In der sechsten Zeile sind adaptive Funktionsblöcke vorgesehen, wie Filter und Algorithmen.

In der Tiefe finden sich drei Ebenen, wobei die in der ersten Ebene angeordneten Funktionalitäten der niedrigsten zur Verfügung stehenden Klasse 'BASIC' von Funktionalitäten zugeordnet sind. Die Produktklassifikation von Endress+Hauser spricht in diesem Zusammenhang von Produkten der T-Klasse.

In der zweiten Ebene finden sich die Funktionalitäten, die der Klasse 'STANDARD' von Funktionalitäten entsprechen. Hier spricht die von E+H verwendete ProduktKlassifikation von Produkten der M Klasse.

In der dritten Ebene sind letztlich die Funktionalitäten der Klasse 'ENHANCED' zu finden, die über die Funktionalität der M-Klasse hinausgehen und Produkten der sog. S-Klasse zuzuordnen sind.

Beispielhaft sind die Funktionalitäten eines Feldgeräts 3 der niedrigsten ProduktKlassifikation ausgewählt - in Fig. 2 sind die ausgewählten Funktionsmodule 4 mit einem Kreis versehen. Es handelt sich bei dem partiell konfigurierten Feldgerät 3 um ein radiometrisches Feldgerät, das den Füllstand eines Füllguts in einem Behälter bestimmt, und das als Messwert ein 4-20mA Signal ausgibt. Desweiteren ist eine Ein-/Ausgabeeinheit vorgesehen und das Feldgerät ist in der Lage, über das HART Protokoll zu kommunizieren.

### Bezugszeichenliste

- 1: Sensor
- 2: Kontroll-/Auswerteeinheit
- 3: Feldgerät
- 4: Funktionsmodul
- 5: Mikroprozessor
- 6: A/D-Wandler
- 7: Signalsfilter
- 8: Skalierung von Auswertealgorithmen
- 9: Modem
- 10: Stromsteuereinheit
- 11: Ansteuereinheit
- 12: Bedientool
- 13: D/A-Wandler
- 14: Funktionsblock
- 15: Analoge Schnittstelle
- 16: Digitale Schnittstelle
- 17: Display
- 18: Speichereinheit: RAM / ROM / FLASH
- 19: EEPROM
- 20: UART
- 21: Powerfail RESET
- 22: physikalische Schnittstelle
- 23: Mikrocontroller
- 24: Schnittstelle
- 25: Schnittstelle
- 26: Überwachungsfunktion

## Patentansprüche

1. Feldgerät zur Bestimmung oder Überwachung einer Prozessgröße in der Prozessautomatisierung, bestehend aus einem Sensor (1), der nach einem definierten Messprinzip arbeitet, und einer Kontroll-/Auswerteeinheit (2), die die vom Sensor (1) gelieferten Messdaten aufbereitet und auswertet,
**dadurch gekennzeichnet,**
**dass** die Kontroll-/Auswerteeinheit (2) als partiell dymamisch rekonfigurierbarer Logikbaustein FPGA mit mehreren dynamisch rekonfigurierbaren Funktionsmodulen (4) ausgebildet ist,
**dass** eine Schnittstelle (25) vorgesehen ist, über die die Kontroll-/Auswerteeinheit (2) sensor- und applikationsspezifische Information über einen definierten Sensortyp in einer jeweils definierten Prozess-Applikation erhält, und
**dass** die Kontroll-/Auswerteeinheit (2) die Funktionsmodule (4) entsprechend der sensor- und applikationsspezifischen Information so konfiguriert, dass das Feldgerät (3) optimal an die zu bestimmende bzw. zu überwachende Prozessgröße und an die aktuelle Prozess-Applikation des Feldgeräts (3) angepasst ist.

2. Feldgerät nach einem oder mehreren der vorhergehenden Arsprüche, wobei die sensor- und applikationspezifische Information der Kontroll-/Auswerteeinheit (2) im Rahmen der Produktion des Feldgeräts (3) oder im laufenden Messbetrieb bereitgestellt wird.

3. Feldgerät nach Anspruch 1, wobei es sich bei den Funktionsmodulen (4) beispielsweise um Mikroprozessoren (23) mit unterschiedlicher Bus-Rate, um A/ D-Wandler (6.1, 6.2,..) oder D/A-Wandler (13.1, 13.2, ..) mit unterschiedlicher Bit-Auflösung (8bit, 16,bit, 21bist, ..), um Signalfilter (7a.1, 7a.2,..; 7b.1, 7b.2, ..) mit unterschiedlichen Filterfunktionen, um unterschiedliche Skalierungen (8.1., 8.2, ..) von Auswertealgorithmen, um unterschiedliche Modems (9.1, 9.2, ..) um unterschiedliche Stromsteuereinheiten (10.1., 10.2.,...) oder um Ansteuereinheiten (11.1., 11.2., ...) für unterschiedliche Ein-/Ausgabe-einheiten (12.1 / 17.1, 12.2 / 17.2, ..) handelt.

4. Feldgerät nach Anspruch 1, wobei die Kontroll-/Auswerteeinheit (2) neben dem dynamischen Bereich (DB) zumindest einen statischen Bereich (SB) aufweist, in dem eine Basiskomponente, wie beispielsweise ein Mikrocontroller (23), permanent konfiguriert ist.

5. Feldgerät nach Anspruch 1 oder 2, wobei es sich bei der sensorspezifischen Information um Information handelt, die den Sensor (1) in seiner Funktion zur Bestimmung oder Überwachung einer Prozessgröße über ein definiertes Messprinzip kennzeichnet.

6. Feldgerät nach Anspruch 1 oder 5, dass es sich bei der Prozessgröße um den Füllstand, den Druck, den Durchfluss, die Temperatur, die Leitfähigkeit, den pH-Wert, die Trübung, die Dichte, die Viskosität oder die Konzentration eines chemischen Stoffes handelt.

7. Feldgerät nach Anspruch 1, das es sich bei der applikationsspezifischen Information um Information über die definierte Anwendung handelt, in der der Sensors (1) im Prozess eingesetzt ist.

8. Feldgerät nach Anspruch 1 oder 7, wobei es sich bei der applikationspezifischen Information um die Information handelt, in welcher Betriebsart, z.B. Druckmessung, Füllstandsmessung, Durchflussmessung, der nach einem definierten Messprinzip arbeitende Sensor (1), z.B. ein Drucksensor, arbeitet.

9. Feldgerät nach Anspruch 1 oder 2, wobei es sich bei der applikationspezifischen Information um die Information handelt, ob das Feldgerät (3) in einem Prozess mit im wesentlichen konstanten Werten der Prozessgröße oder sich sprunghaft ändernden Werten der Prozessgröße eingesetzt ist.

10. Feldgerät nach Anspruch 1, 2 oder 9, dass im laufenden Messbetrieb eine Überwachungsfunktion (26) überprüft, ob sprunghafte Änderungen der Prozessgröße auftreten, und das die Kontroll-/Auswerteeinheit (2) im Falle sich sprunghaft ändernder Werte der Prozessgröße Funktionsmodule (4), insbesondere den A/D-Wandler (6), den D/A- Wandler (13) und das Signalfilter (7a, 7b), mit einer niedrigeren Auflösung und einer höheren Verarbeitungsgeschwindigkeit konfiguriert als im Falle sich langsam ändernder oder konstanter Werte der Prozessgröße.

11. Feldgerät nach Anspruch 1, 2 oder 9, dass die Kontroll-/Auswerteeinheit (2) parallele Zweige von Funktions-modulen (4) konfiguriert, die einerseits zur Verarbeitung von sich sprunghaft ändernden Prozessgrößen geeignet sind, und die andererseits zur Verarbeitung von sich im wesentlichen kontinuierlich ändernden Prozess-größen geeignet sind, und dass die Überwachungsfunktion (26) je nach Fall den geeigneten Zweig von Funktionsmodulen (4) ansteuert

## Claims

1. Field device for determining or monitoring a process variable in process automation, consisting of a sensor (1) that works according to a defined measuring principle, and a control/evaluation unit (2) which prepares and evaluates the measured data supplied by the sensor (1),
**characterized in that**
the control/evaluation unit (2) is designed as a FPGA logic module which can be reconfigured partially dynamically with multiple dynamically reconfigurable function modules (4),
**in that** an interface (25) is provided via which the control/evaluation unit (2) receives sensor-specific and application-specific information about a defined sensor type in a defined process application, and
**in that** the control/evaluation unit (2) configures the function modules (4) in accordance with the sensor-specific and application-specific information in such a way that the field device (3) is optimally adapted to the process variable to be determined or to be monitored and to the current process application of the field device (3).

2. Field device as claimed in one or more of the previous claims, wherein the sensor-specific and application-specific information is made available to the control/evaluation unit (2) within the framework of the production of the field device (3) or during ongoing measuring operation.

3. Field device as claimed in Claim 1, wherein the function modules (4) are, for example, microprocessors (23) with different bus rates, A/D converters (6.1, 6.2, ...) or D/A converters (13.1, 13.2, ...) with different bit resolutions (8 bit, 16 bit, 21 bit, ...), signal filters (7a.1, 7a.2, ... ; 7b.1, 7b.2, ...) with different filter functions, different scalings (8.1, 8.2, ...) of evaluation algorithms, different modems (9.1, 9.2, ...), different power control units (10.1, 10.2, ...) or control units (11.1, 11.2, ...) for different input/output units (12.1 / 17.1, 12.2/17.2, ...).

4. Field device as claimed in Claim 1, wherein in addition to the dynamic zone (DB) the control/evaluation unit (2) has at least a static zone (SB) in which a basic component, such as a microcontroller (23), is permanently configured.

5. Field device as claimed in Claim 1 or 2, wherein the sensor-specific information is information which characterizes the sensor (1) in its function of determining or monitoring a process variable by means of a defined measuring principle.

6. Field device as claimed in Claim 1 or 5, wherein the process variable is the level, the pressure, the flow, the temperature, the conductivity, the pH value, the turbidity, the density, the viscosity or the concentration of a chemical substance.

7. Field device as claimed in Claim 1, wherein the application-specific information is information about the defined application in which the sensor (1) is used in the process.

8. Field device as claimed in Claim 1 or 7, wherein the application-specific information is information about the operating mode, such as pressure measurement, level measurement, flow measurement, for example, in which the sensor (1) that works according to a defined measuring principle - such as a pressure sensor for instance - operates.

9. Field device as claimed in Claim 1 or 2, wherein the application-specific information is information about whether the field device (3) is used in a process with essentially constant values for the process variable, or with abruptly changing values for the process variable.

10. Field device as claimed in Claim 1, 2 or 9, wherein during ongoing measuring operation a monitoring function (26) checks whether abrupt changes occur in the process variable, and wherein, in the event of abruptly changing values for the process variable, the control/evaluation unit (2) configures function modules (4), particularly the A/D converter (6), the D/A converter (13) and the signal filter (7a, 7b) with a lower resolution and a higher processing speed than in the event of slowly changing values or constant values for the process variable.

11. Field device as claimed in Claim 1, 2 or 9, **characterized in that** the control/evaluation unit (2) configures parallel branches of function modules (4) which, on the one hand, are suitable for the processing of process variables that change abruptly, and which, on the other hand, are suitable for the processing of process variables that essentially change continuously, and **in that** the monitoring function (26) controls the suitable branch of function modules (4) depending on the particular case.

## Revendications

1. Appareil de terrain destiné à la détermination ou la surveillance d'une grandeur process dans l'automatisation des process, composé d'un capteur (1) fonctionnant d'après un principe de mesure défini, et d'une unité de contrôle / d'exploitation (2) qui traite et exploite les données de mesure fournies par le capteur (1),
**caractérisé**
**en ce que** l'unité de contrôle / d'exploitation (2) est conçue en tant que composant logique FPGA partiellement dynamique avec plusieurs modules de fonction (4) reconfigurables de façon dynamique,
**en ce qu'**est prévue une interface (25), par l'intermédiaire de laquelle l'unité de contrôle / d'exploitation (2) reçoit l'information spécifique au capteur et à l'application par le biais d'un type de capteur défini dans une application process définie correspondante, et
**en ce que** l'unité de contrôle / d'exploitation (2) configure les modules de fonction (4) conformément à l'information spécifique au capteur et à l'application, de telle manière que l'appareil de terrain (3) soit adapté de façon optimale à la grandeur process à déterminer ou à surveiller, ainsi qu'à l'application process actuelle de l'appareil de terrain (3).

2. Appareil de terrain selon l'une ou plusieurs des revendications précédentes, pour lequel l'information spécifique au capteur et à l'application est mise à la disposition de l'unité de contrôle / d'exploitation (2) dans le cadre de la production de l'appareil de terrain (3) ou pendant le mode de mesure courant.

3. Appareil de terrain selon la revendication 1, pour lequel il s'agit, concernant les modules de fonction (4), par exemple de microprocesseurs (23) avec différentes cadences de bus, de convertisseurs A/N (6.1, 6.2, ...) ou de convertisseurs N/A (13.1, 13.2, ...) avec différentes résolutions binaires (8 bits, 16 bits, 21 bits, ...), de filtres de signaux (7a.1, 7a.2, ... ; 7b.1, 7b.2, ...) avec différentes fonctions de filtre, de différentes évolutions (8.1, 8.2, ...) d'algorithmes d'exploitation, de différents modems (9.1, 9.2, ...), de différentes unités de régulation de courant (10.1, 10.2, ...) ou d'unités de commande (11.1, 11.2, ...) pour différentes unités d'entrées/sorties (12.1 / 17.1, 12.2/17.2, ...).

4. Appareil de terrain selon la revendication 1, pour lequel l'unité de contrôle / d'exploitation (2) comporte, outre la zone dynamique (DB), au moins une zone statique (SB) dans laquelle est configurée de façon permanente un composant de base, tel qu'un microcontrôleur (23).

5. Appareil de terrain selon la revendication 1 ou 2, pour lequel il s'agit, concernant l'information spécifique au capteur, d'une information caractérisant le capteur (1) dans sa fonction en vue de la détermination ou de la surveillance d'une grandeur process au moyen d'un principe de mesure défini.

6. Appareil de terrain selon la revendication 1 ou 5, pour lequel il s'agit, concernant la grandeur process, du niveau, de la pression, du débit, de la température, de la conductivité, du pH, de la turbidité, de la densité, de la viscosité ou de la concentration d'une substance chimique.

7. Appareil de terrain selon la revendication 1, pour lequel il s'agit, concernant l'information spécifique à l'application, d'une information sur l'application définie, dans laquelle le capteur (1) est utilisé dans le process.

8. Appareil de terrain selon la revendication 1 ou 7, pour lequel il s'agit, concernant l'information spécifique à l'application, de l'information indiquant le mode de fonctionnement, p. ex. mesure de pression, mesure de niveau, mesure de débit, dans lequel se trouve le capteur (1), p. ex. un capteur de pression, fonctionnant d'après un principe de mesure défini.

9. Appareil de terrain selon la revendication 1 ou 2, pour lequel il s'agit, concernant l'information spécifique à l'application, de l'information indiquant si l'appareil de terrain (3) est utilisé dans un process avec pour l'essentiel des valeurs constantes de la grandeur process ou des valeurs à variations rapides de la grandeur process.

10. Appareil de terrain selon la revendication 1, 2 ou 9, qui contrôle pendant le mode de mesure courant une fonction de surveillance (26), afin de déterminer si des variations brusques de la grandeur process apparaissent, et **caractérisé en ce que** l'unité de contrôle / d'exploitation (2) configure, dans le cas de valeurs à variations rapides de la grandeur process, des modules de fonction (4), notamment le convertisseur A/N (6), le convertisseur N/A (13) et le filtre de signaux (7a, 7b) avec une résolution inférieure et une vitesse de traitement supérieure à celles configurées dans le cas de valeurs à variations lentes ou constantes de la grandeur process.

11. Appareil de terrain selon la revendication 1, 2 ou 9, **caractérisé en ce que** l'unité de contrôle / d'exploitation (2) configure des branches parallèles de modules de fonction (4) qui, d'une part, sont appropriées pour le traitement de grandeurs process à variations rapides et qui, d'autre part, sont appropriées pour le traitement de grandeurs process variant pour l'essentiel de façon continue, et **en ce que** la fonction de surveillance (26) commande selon le cas la branche appropriée de modules de fonction (4).
